# EUROPEAN PATENT APPLICATION

(11) **EP 4 750 241 A1**
(43) Date of publication of application: **27.05.2026**
(21) Application number: 25217669.8
(22) Date of filing: 21.11.2025
(51) Int. Cl.: H05K 7/20

(54) **IN-RACK COOLING UNITS**

(30) Priority: 21.11.2024 US 202463723429 P
(71) Applicant: Schroff GmbH, 75334 Straubenhardt (DE)
(72) Inventor: Adel, Hassan Elsheshtawy, Dobel (DE); Euchner, Heinz, Straubenhardt (DE); Bandel, Richard, Trinbach (FR); Müller, Jochen, Straubenhardt (DE); Wagner, Nick Owen, Straubenhardt (DE)
(74) Representative: Barker Brettell LLP

(57) **Abstract**

An in-rack cooling unit for cooling electrical equipment within a rack can include a casing having an air inlet, an air outlet, a top panel, and a bottom panel defining a longitudinal plane. A distance between the top panel and the bottom panel can define a height of the casing that is less than 6 rack units. The casing can further include a fluid inlet and a fluid outlet. A heat exchanger can be fluidly connected between the fluid inlet and the fluid outlet. A fan can define a rotational axis that extends at a first oblique angle relative to the longitudinal plane, with the fan pulling air from the air inlet across the heat exchanger and discharging conditioned air through the air outlet in a direction different than the rotational axis.

## Description

### CROSS-REFERENCE TO RELATED APPLICATIONS

This application claims the benefit of U.S. Provisional Patent Application No. 63/723,429, filed November 21, 2024, which is incorporated herein by reference in its entirety.

### BACKGROUND

Cooling systems can be provided for electrical components in data centers. In some examples, equipment in a data center can be cooled through various means, including through liquid-based cooling systems, air-based cooling systems, or combinations thereof. Electrical equipment (e.g., servers) within a data center can be housed in racks. A cooling unit can be provided to provide a heat transfer to remove heat from the electrical equipment.

### SUMMARY

According to one aspect of the present disclosure, an in-rack cooling unit for cooling electrical equipment within a rack can include a casing. The casing can include an air inlet, an air outlet, a top panel, and a bottom panel defining a longitudinal plane. A distance between the top panel and the bottom panel can define a height of the casing that is less than 6 rack units. The casing can further include a fluid inlet and a fluid outlet. A heat exchanger can be fluidly connected between the fluid inlet and the fluid outlet. A fan can define a rotational axis that extends at a first oblique angle relative to the longitudinal plane. The fan can pull air from the air inlet across the heat exchanger and can discharge conditioned air through the air outlet in a direction different than the rotational axis.

In some examples, the heat exchanger can be an air-to-liquid heat exchanger or a liquid-to-air heat exchanger.

In some examples, the height of the casing can be less than 4 rack units.

In some examples, the fan can draw air into an inlet side of the fan at the first oblique angle and discharges air from an outlet side of the fan at a second oblique angle that is 90 degrees offset from the first oblique angle.

In some examples, the fan can be oriented at the first oblique angle of between about 20 degrees and about 50 degrees relative to the longitudinal plane.

In some examples, the heat exchanger can be oriented at a third oblique angle of between about 10 degrees and about 20 degrees relative to the longitudinal plane.

In some examples, the fan can be angled toward the heat exchanger.

In some examples, the in-rack cooling unit can provide a cooling capacity of between about 7 kW and about 8 kW.

In some examples, the fan can pull air from the air inlet across the heat exchanger in a direction different than the rotational axis.

In some examples, the bottom panel can include a first bottom panel portion supporting the heat exchanger and a second bottom panel portion supporting the fan. A first seal can be arranged between the first bottom panel portion and the second bottom panel portion.

In some examples, the top panel can include a first top panel portion and a second top panel portion that includes the air inlet or the air outlet. A second seal can be arranged between the first top panel portion and the second top panel portion.

In some examples, the in-rack cooling unit can further include a bracket that supports the fan at the first oblique angle.

In some examples, the bracket can be an adjustable bracket that provides a user to adjust the first oblique angle between about 20 degrees and about 50 degrees.

According to another aspect of the present disclosure, an in-rack cooling unit can include a casing defining an inner volume, an air inlet, and an air outlet at an opposite side of the casing from the air inlet. The casing can define a longitudinal axis separating the air inlet from the air outlet. A heat exchanger can be arranged within the inner volume of the casing. A fan assembly can be arranged within the inner volume of the casing. The fan assembly can induce a flow of air through the casing from the air inlet, across the heat exchanger, and through the air outlet. The air can pass into a fan of the fan assembly at a first oblique angle relative to the longitudinal axis and can pass out of the fan at a second oblique angle relative to the longitudinal axis that is offset from the first oblique angle.

In some examples, the fan assembly can be angled toward the heat exchanger. The fan assembly can be oriented at an angle between about 20 degrees and about 50 degrees relative to the longitudinal axis. The heat exchanger can be oriented at an angle between about 10 degrees and about 20 degrees relative to the longitudinal axis.

In some examples, the casing can define a height that is less than 6 rack units.

In some examples, the fan assembly can draw air from the heat exchanger in a direction substantially parallel to the longitudinal axis and can discharge air from the fan at the first oblique angle.

In some examples, the in-rack cooling unit can further include an adjustable bracket that supports the fan assembly at the second oblique angle.

According to yet another aspect of the present disclosure, a method of cooling electrical equipment within a rack can include providing an in-rack cooling unit having a casing that includes an air inlet and an air outlet. The casing can have a height of less than 6 rack units. The method can include providing a heat exchanger that includes a liquid inlet and a liquid outlet within the casing. The method can include orienting a plurality of fans within the casing at a first oblique angle relative to a longitudinal plane that extends between the air inlet and the air outlet of the casing. The method can include inducing a flow of air from the air inlet across the heat exchanger using the plurality of fans. The method can include discharging conditioned air through the air outlet in a direction different than the first oblique angle.

In some examples, the method can further include positioning the heat exchanger at a second oblique angle relative to the longitudinal plane such that the plurality of fans and the heat exchanger converge toward each other.

Aspects and embodiments of the invention are defined in the claims. Feature(s) of the aspects/embodiments of the invention or features otherwise disclosed herein may be used separately, together and/or be interchangeable wherever possible. Where features are, for brevity, described in the context of a single embodiment, those features may also be provided separately or in any suitable sub-combination. Features described in connection with the in-rack cooling unit or any feature(s) or component(s) described may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate examples of the disclosed technology and, together with the description, serve to explain the principles of examples of the disclosed technology:
FIG. 1 is a diagrammatic view of an electronics cabinet according to aspects of the present disclosure.
FIG. 2 is a top axonometric view of a cooling unit of an electronics cabinet according to aspects of the present disclosure.
FIG. 3 is another top axonometric view of the cooling unit of FIG. 2, with a casing of the cooling unit partially removed.
FIG. 4 is a front elevation view of the cooling unit of FIG. 3.
FIG. 5 is a rear elevation view of the cooling unit of FIG. 3.
FIG. 6 is a top elevation view of the cooling unit of FIG. 3.
FIG. 7 is a first side elevation view of the cooling unit of FIG. 3.
FIG. 8 is a second side elevation view of the cooling unit of FIG. 3.
FIG. 9 is a top axonometric view of a cooling unit according to aspects of the present disclosure.
FIG. 10 is another top axonometric view of the cooling unit of FIG. 9, showing a casing of the cooling unit partially removed.
FIG. 11 is a front elevation view of the cooling unit of FIG. 9.
FIG. 12 is a rear elevation view of the cooling unit of FIG. 9.
FIG. 13 is a top elevation view of the cooling unit of FIG. 9.
FIG. 14 is a first side elevation view of the cooling unit of FIG. 9.
FIG. 15 is a second side elevation view of the cooling unit of FIG. 9.
FIG. 16 is a detailed view of area 16-16 of FIG. 12, showing details of the casing of the cooling unit.
FIG. 17 is a detailed view of area 17-17 of FIG. 12, showing details of the casing of the cooling unit.
FIG. 18 is a partial view of a cabinet of electrical equipment including the cooling unit of FIG. 2.

### DETAILED DESCRIPTION

Before any examples of the disclosed technology are explained in detail, it is to be understood that the disclosed technology is not limited in its application to the details of construction and the arrangement of components set forth in the following description or illustrated in the following drawings. The disclosed technology is capable of other examples and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The following discussion is presented to enable a person skilled in the art to make and use examples of the present disclosure. Various modifications to the illustrated examples will be readily apparent to those skilled in the art, and the generic principles herein can be applied to other examples and applications without departing from examples of the present disclosure. Thus, examples of the present disclosure are not intended to be limited to examples shown but are to be accorded the widest scope consistent with the principles and features disclosed herein. The following detailed description is to be read with reference to the figures, in which like elements in different figures have like reference numerals. The figures, which are not necessarily to scale, depict selected examples and are not intended to limit the scope of examples of the present disclosure. Skilled artisans will recognize the examples provided herein have many useful alternatives and fall within the scope of examples of the present disclosure.

Cooling systems can be provided for data centers to cool electrical components within an electronics enclosure at a data center. During operation, electrical components which are typically housed in racks or electronics cabinets can generate heat, which may degrade electrical components, damage the systems, or degrade performance of the components. Thus, cooling units can be provided to transfer the generated heat away from racks of the data center. For example, cooling units can be arranged within the electronics cabinets to facilitate the heat transfer. However, in some examples, cooling units can occupy a significant amount of space within the electronics cabinets, and it may be challenging to provide additional electrical components for additional computing power.

Examples of the disclosed technology can provide improvements in this regard, and various others as further detailed below. In particular, some examples of the disclosed technology can provide configurations of cooling units and associated support structures that allow for a compact arrangement of various components within a cooling unit.

In some examples, subcomponents of a cooling unit can be provided at an angle relative to a cooling unit frame. For example, a fan assembly or a heat exchanger can be arranged in the cooling unit at an angle (e.g., in contrast with a vertical, upright position) and occupy a smaller amount of vertical space. In some examples, orienting the fan assembly or the heat exchanger at an angle can allow for a shorter height of a cooling unit, which can accordingly free up space for other components (e.g., an additional server unit) to fit within the electronics cabinet as well. These concepts can be practiced on various electronics cabinet or coolant distribution units, as will be described below.

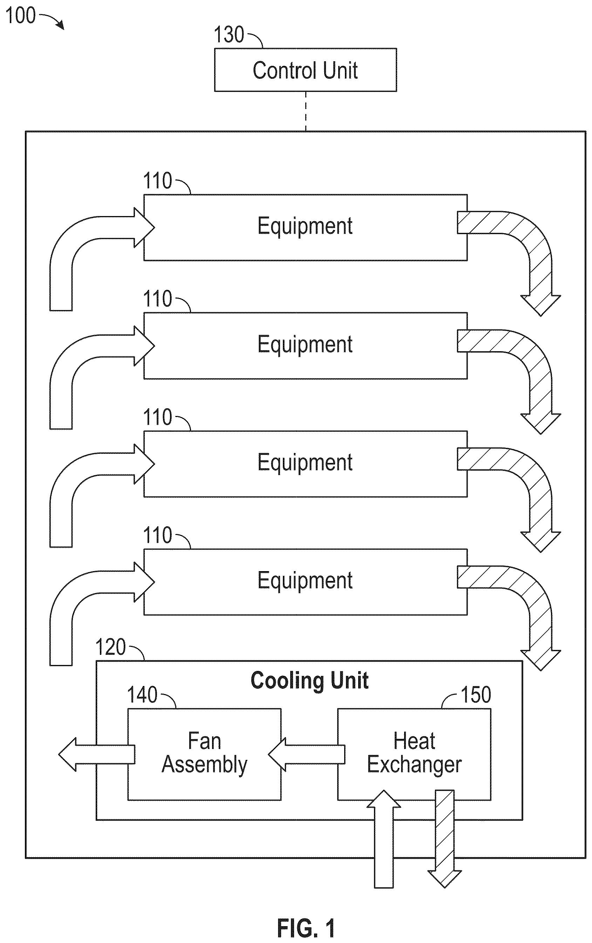

FIG. 1 is a block diagram that illustrates an electronics cabinet 100, according to some examples of the disclosed technology. The electronics cabinet 100 can be any of a number of different types of electronics cabinets upon which examples discussed below can be advantageously incorporated. For example, the electronics cabinet 100 can be a server rack, including a plurality of computing servers arranged in vertically consecutive shelves of the cabinet 100. In some examples, the cabinet 100 can house networking equipment (e.g., switches, routers, etc.), storage equipment (e.g., flash drives, disc shelves, etc.), energy storage systems (e.g., battery modules, etc.), or a combination of one or more of computing servers, network equipment, storage equipment, energy storage systems, etc. In some examples, the electronics cabinet 100 can include cooling systems (e.g., rear-door cooling units, coolant distribution units, heat exchangers, pumping units, etc.) for cooling various electrical components at data centers. Accordingly, the electronics cabinet 100 can support various network of servers and equipment for operation of data centers.

In some applications, the electronics cabinet 100 can be provided at various locations such as edge data centers. In some examples, the electronics cabinet 100 can be provided proximate to a location of an application, for example, to reduce latency of data processing or improving user experience by co-locating near a computing station or loads serviced by the computing station. In some examples, the electronics cabinet 100 can be provided in geographic areas or environments that are remote or limited in space and weight capacity, such as nautical vessels, aircrafts, research centers, field hospitals, remote clinics, etc. Accordingly, providing a data center with multiple, heavy cooling systems or server racks may be challenging in some locations. Thus, it may be advantageous to provide the electronics cabinet 100 with improved computing power, improved cooling capacity, or cooling systems that are self-sustainable and free of additional equipment.

In particular, FIG. 1 illustrates relationships between various systems on the electronics cabinet 100. For example, the electronics cabinet 100 can house heat-generating electrical equipment 110 (e.g., a plurality of servers, network switches or routers, storage discs or drives, energy storage systems, or some combination thereof), a cooling unit 120, and a control unit 130. In some examples, the cooling unit 120 can be provided at a lower portion of the electronics cabinet 100 to cool the electrical equipment 110. In some examples, the control unit 130 can control one or more aspects of the electronics cabinet 100, including operation of the cooling unit 120 or the electrical equipment 110. In some examples, the control unit 130 can be housed within the cooling unit 120. In some examples, a cooling unit (e.g., the cooling unit 120) can be controlled remotely and a controller can be arranged outside of the cooling unit (e.g., housed within the rack of electrical equipment hosting the cooling unit, or externally to the rack).

The cooling unit 120 can include a fan assembly 140 and a heat exchanger 150. In the illustrated example, the heat exchanger 150 is an air-to-liquid heat exchanger and a flow of coolant (e.g., a facility water) through the heat exchanger 150 can be induced through the heat exchanger 150. The fan assembly 140 can induce a flow of air across the heat exchanger 150, and a heat from the air can be transferred to the fluid coolant flowing through the heat exchanger 150 to transfer a heat out of the cabinet 100. As shown, cooled air can flow out of the cooling unit 120 (e.g., at a supply side) in a direction towards the electrical equipment 110 (e.g., upwardly, as shown), and can flow across the electrical equipment 110 to transfer a heat from the electrical equipment 110. A heated air can flow out of the electrical equipment 110 and into the cooling unit 120 (e.g., at a return side of the cooling unit 120) and can be cooled at the heat exchanger 150. Thus, as illustrated by arrows of FIG. 1, cool fluids of the heat exchanger 150 can lower temperature of hot air released from the electrical equipment 110 and return the fluids as hot fluids, and the fan assembly 140 can provide a flow of cooled air to the electrical equipment, or into a cold aisle of a data center that the electronics cabinet 100 is provided, or other components that may be advantageous to cool.

In some examples, the heat transfer fluids (e.g., cool fluids or hot fluids) that flow through heat exchanger coils may not need to be processed to achieve specific characteristics of the fluids, such as a pH level or temperature. Accordingly, the electronics cabinet 100 can accommodate various settings, including environments that are free of liquid cooling racks (e.g., for high density liquid cooling). While the illustrated example includes the heat exchanger 150 that is air-to-liquid, other examples can include other types of heat exchangers, such as liquid-to-air, liquid-to-liquid, air-to-air, or immersion cooling. In some examples, the cooling unit 120 can distribute a coolant (e.g., water, a water glycol mixture, propylene, a dielectric fluid, etc.) to upstream equipment via a pump. In some examples, a cooling unit installable within a rack of electrical equipment (e.g., the cooling unit 120) can include a refrigeration cycle (e.g., a heat can be transferred away from the air at an evaporator and can be transferred to a facility water at a condenser). For example, if an approach temperature of the heat exchanger 150 is beneath a threshold for effective heat transfer, refrigerant-based cooling can be activated to continue to provide a cooling capacity.

In some configurations, the electronics cabinet 100 can be sized according to industry standards, regulations, locations, or types of applications. For example, the electronics cabinet 100 can define a height that is 42 rack units (Us), with 1U corresponding to 1.75 inches or about 44.44 mm. In some examples, the electronics cabinet 100 can support one or more electrical equipment 110 that are 2U, 4U, 6U, or so forth, or include one or more cooling units that are 7U or less, 6U or less, 5U or less, 4U or less, etc. In some examples, a size of the electronics cabinet 100 can be adjusted to support a different number of the electrical equipment 110 or the cooling unit 120. In some examples, a size of the electrical equipment 110 or the cooling unit 120 can be adjusted to fit more or fewer of the electrical equipment 110 or the cooling unit 120 within the electronics cabinet 100. For example, a size of the cooling unit 120 can be decreased to support additional electrical equipment like server units in the remaining space of the electronics cabinet 100. In some examples, different arrangements or configuration of the electrical equipment 110, the cooling unit 120, or the electronic cabinet 100 are possible to maximize existing space within the electronics cabinet 100. In some examples, a width or a depth of the cooling unit 120 can be adjusted to accommodate different applications and form factors, such as configurations ranging from about 600 mm to about 800 mm in depth to suit spatial requirements in various applications as discussed above.

In some examples, material selection for components of the cooling unit 120 can be associated with specific operational requirements and environmental conditions. The materials can be selected based on factors such as thermal conductivity, corrosion resistance, weight considerations, cost effectiveness, and compatibility with various coolant types. For example, the electronics cabinet 100 can include materials that support a weight of components arranged within the electronics cabinet 100. For example, weights of some of the components, including the electrical equipment 110, can add a significant amount of weight to an overall weight of the electronics cabinet 100. Thus, it may be beneficial to provide the electronics cabinet 100 with materials that are lightweight or can withstand a load of the components housed within. For example, materials of the electronics cabinet 100 or the cooling unit 120 can include steel, stainless steel, aluminum, titanium, magnesium, brass, copper, composite materials, or any combinations of materials. In some examples, the coils of the heat exchanger 150 can be constructed from materials including copper, stainless steel, aluminum, brass, nickel alloys, titanium, or any combinations thereof.

In some examples, it can be advantageous to minimize a space required for cooling units (e.g., cooling unit 120) within a rack (e.g., the cabinet 100 shown in FIG. 1). For example, reducing a height of a cooling unit within a rack of electrical equipment can allow for installation of additional electrical equipment within the rack. So, for example, reducing a height of a cooling unit by 1U over conventional in-rack cooling units can allow for the insertion of an additional server (e.g., a server having a height of 1U or 2U) into the rack, as can advantageously increase a computing capacity and density of the rack (e.g., a computing capacity per areal footprint of the rack). Increasing a computing density of a rack can be particularly important in edge computing contexts where it can be impractical or impossible to rely on a data center for computing capacity. For example, high-density computing systems (e.g., a rack with electrical equipment) can be required in remote research labs, in nautical contexts (e.g., aboard ships or submarines), in aerial applications (e.g., aboard aircraft), etc. Examples of the present disclosure can allow for high-density computing racks in part by providing cooling units for cooling the rack with a height of 4U, as can advantageously increase a space available for electrical equipment within the rack relative to conventional cooling units.

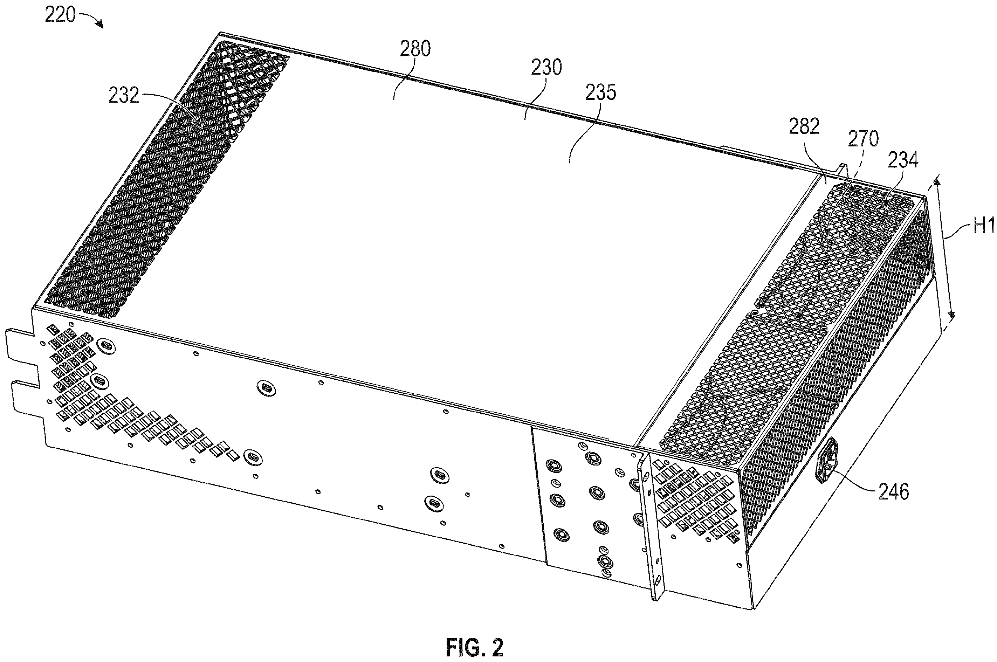

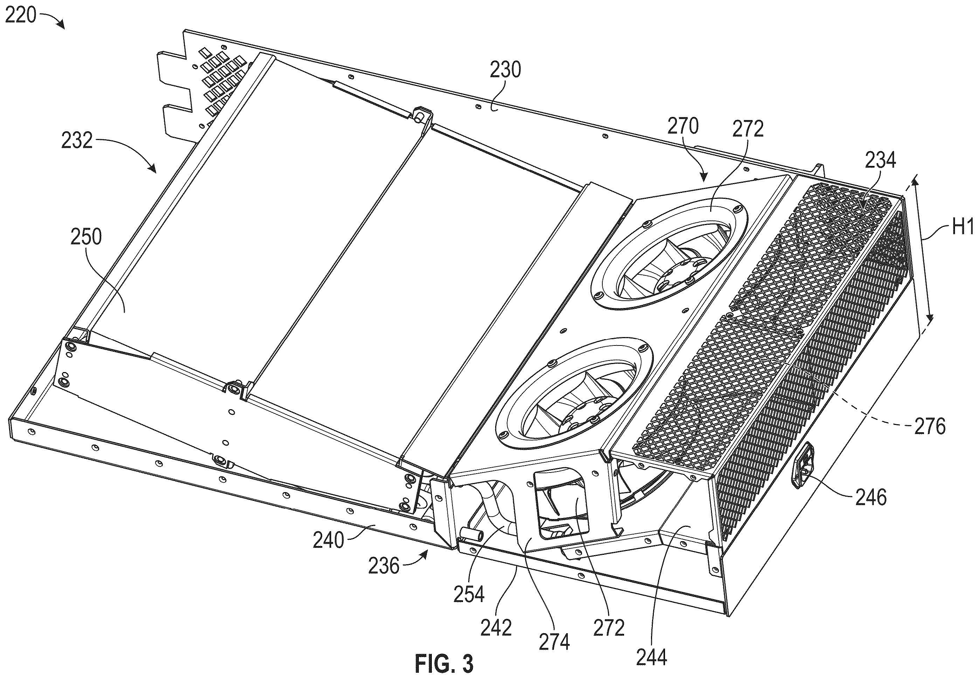

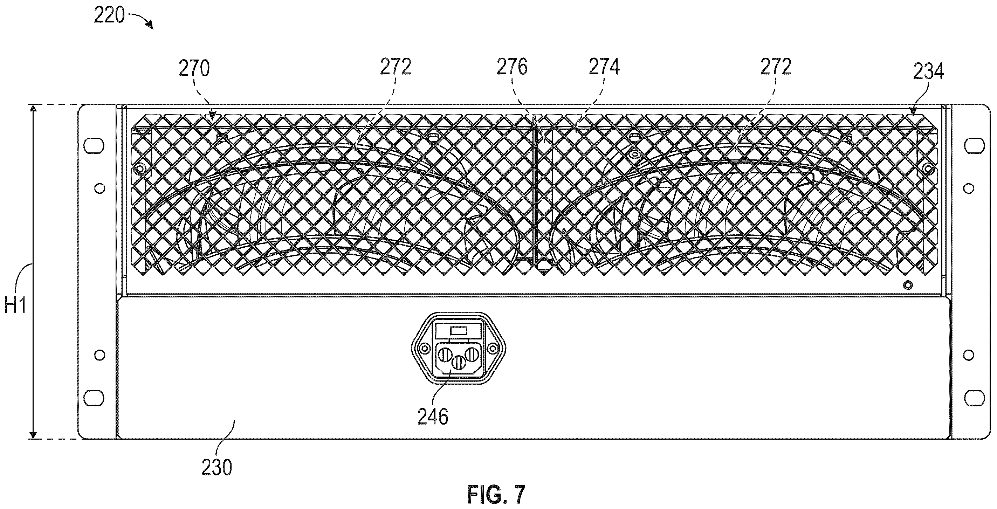

In this regard, FIGS. 2-8 illustrate an example cooling unit 220 for an electronics cabinet, which is a particular example of the cooling unit 120 of FIG. 1. To that end, features of the cooling unit 220 described below include names that are generally similar to those used in FIG. 1, and discussion above applies to similar named items below, unless otherwise noted or required. For example, the cooling unit 220 includes a heat exchanger 250 (shown in FIGS. 3-6) and a fan assembly 270 (shown in FIGS. 3-6), just as the cooling unit 120 includes the fan assembly 140 and the heat exchanger 150. The cooling unit 220 includes a casing 230 that defines an internal space for supporting components of the cooling unit 220. The cooling unit 220 defines a height H1. In some examples, the height H1 extends between a top panel 235 and a bottom panel 236 of the casing 230. In some examples, the height H1 can be 4U, or about 177.6 mm. In some examples, the height H1 can be less than 4U (e.g., such as 3U, 2U, or 1U), or greater than 4U (e.g., such as 5U, 6U, and so forth). The top panel 235 and the bottom panel 236 can define parallel horizontal planes, and the height H1 can be measured between the parallel horizontal planes defined by the top panel 235 and the bottom panel 236. For example, the bottom panel 236 defines a longitudinal axis or plane 238 and includes a length L1 as measured in a direction parallel to the longitudinal plane 238. In some examples, the length L1 can be about 800 mm or less than 800 mm, including 700 mm or 600 mm.

In some examples, the bottom panel 236 can include portions that are dedicated to supporting different components of the cooling unit 220. In the illustrated example, the bottom panel 236 includes a first bottom panel portion 240 and a second bottom panel 242 (e.g., as shown in FIGS. 3-5). The first bottom panel portion 240 can support the heat exchanger 250, and the second bottom panel 242 can support the fan assembly 270. In some examples, this split bottom panel configuration can provide modularity and flexibility for servicing individual components of the cooling unit 220 such as the fan assembly 270.

As shown in FIG. 2, the casing 230 includes an air inlet 232 and an air outlet 234 that are provided on opposite sides of the casing 230. The air inlet 232 and the air outlet 234 extend between opposite ends of the casing 230 along the longitudinal plane 238 that extends between the air inlet 232 and the air outlet 234. In some examples, the top panel 235 can include the air inlet 232 and the air outlet 234. For example, the top panel 235 can include a first top panel portion 280 that includes the air inlet 232 and a second top panel portion 282 that includes the air outlet 234. In some examples, the first top panel portion 280 and the second top panel portion 282 can form a top side and lateral sides of the casing 230. Accordingly, air can be drawn into the internal space of the casing 230 through the top side and a lateral side (e.g., left side as shown in FIG. 2) of the casing 230, and air can be discharged from the internal space of the casing 230 through the top side and a lateral side (e.g., right side as shown in FIG. 2) of the casing 230. In the illustrated example, the air inlet 232 and the air outlet 234 are defined by meshed surfaces, although other types of surfaces can be provided including perforated panels, louvered surfaces, or solid panels with discrete openings. In some examples, the casing 230 can define an airflow channel between the air inlet 232 and the air outlet 234. In the illustrated example, air can flow from the air inlet 232 to the heat exchanger 250 or the fan assembly 270 and out the air outlet 234. In some examples, the heat exchanger 250 can provide a cooling capacity that is greater than 5 kW, greater than 10 kW, greater than 15 kW, greater than 20 kW, greater than 30 kW, greater than 40 kW, between about 7 kW to about 8 kW, or about 7.5 kW. In some examples, sizes of the air inlet 232 and the air outlet 234 can be varied based on desired cooling characteristics such as a flow rate of air.

Referring now to FIGS. 3-6, the heat exchanger 250 is an air-to-liquid heat exchanger including air passageways for air flow through the cooling unit 220. The heat exchanger 250 defines a flow path for a liquid coolant for transferring heat from a flow of air across the heat exchanger 250 to the liquid coolant. In the illustrated example, the cooling unit 220 includes a plug 246 for powering the cooling unit 220 or electronically communicating with the electronics cabinet 100. In some examples, the cooling unit 220 can be hot-swappable and include associated support structures such as rails or quick-connect ports for fluids. In some examples, one or more sub-components of the cooling unit 220 can be interchangeable or hot-swappable (e.g., individual fans of the fan assembly 270, the heat exchanger 250, etc.). In some examples, the cooling unit 220 can be stacked with another cooling unit to increase cooling capacity of an electronics cabinet. In some examples, the casing 230 can be aluminum or other light-weight materials to decrease an overall weight of the cooling unit 220 or an electronics cabinet that includes the cooling unit 220. For example, the cooling unit 220 can weigh less than 23 kilograms or less than 15 kilograms.

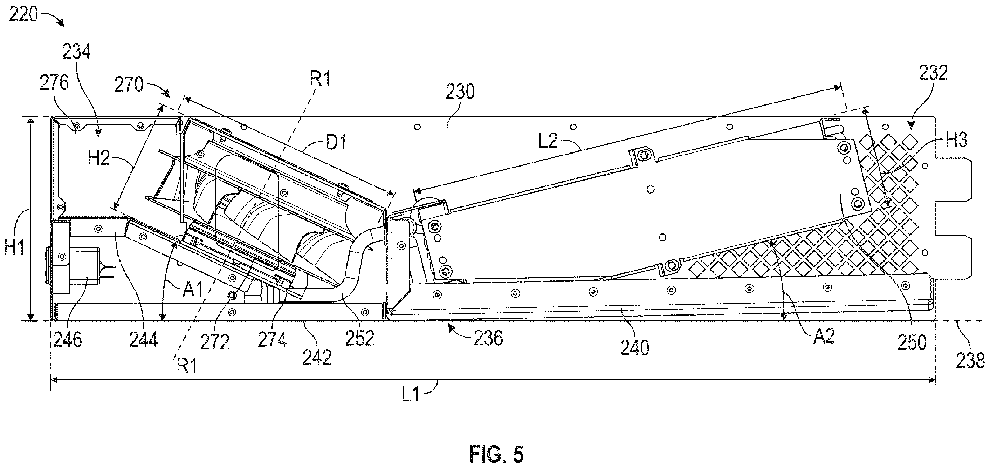

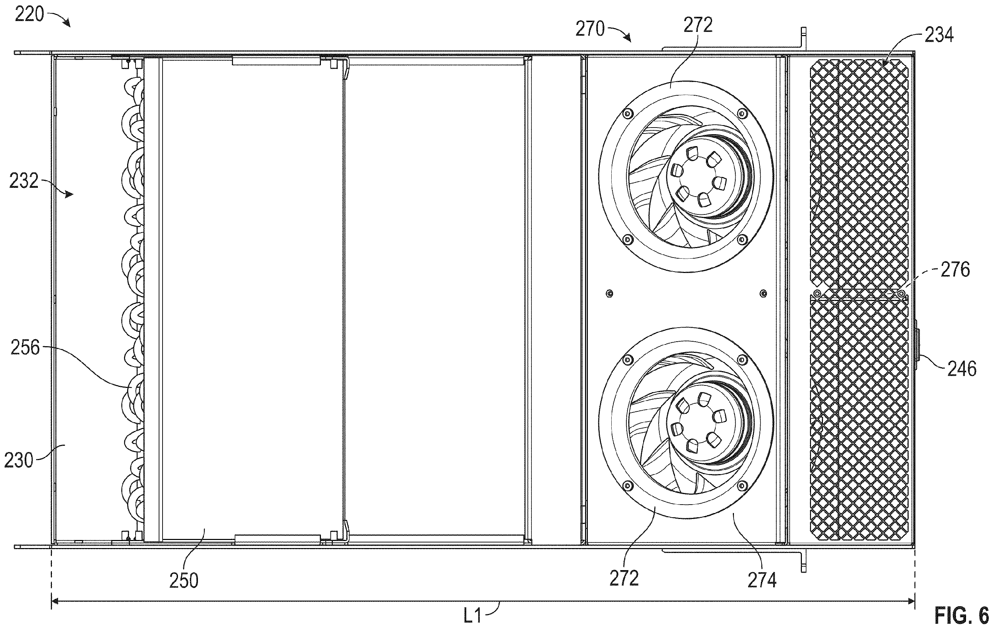

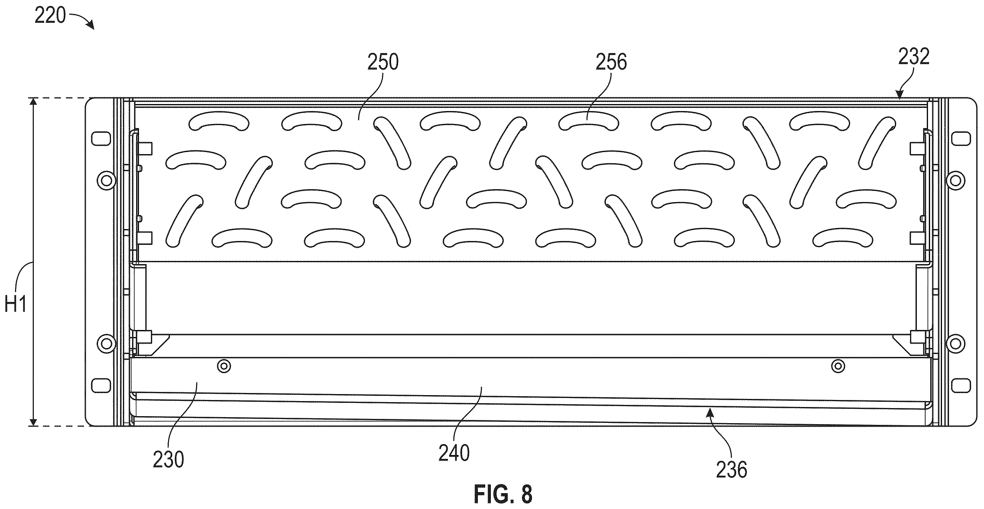

In addition, an in-rack cooling unit can include a fluid inlet and a fluid outlet to allow a flow of coolant (e.g., liquid such as water, mineral oil, glycerol, etc.) through a heat exchanger. FIG. 3 illustrates the heat exchanger 250 and the fan assembly 270 of the cooling unit 220 arranged within the casing 230. The heat exchanger 250 can be provided near the air inlet 232, and hot air can enter through the air inlet 232 toward the heat exchanger 250. Further, the heat exchanger 250 can be in fluid communication with an inlet hose 252 (e.g., a fluid inlet, as shown in FIG. 5) that provides a fluid coolant for heat transfer through coils 256 (e.g., as shown in FIGS. 6 and 8) and an outlet hose 254 (e.g., a fluid outlet) that discharges heated fluids from the coils 256, which can be cooled for subsequent heat transfer cycles.

Continuing, the fan assembly 270 can be arranged near the air outlet 234. In the illustrated example, a distance between the fan assembly 270 and the air outlet 234 can be greater than a distance between the heat exchanger 250 and the air outlet and push the cooled air to downstream systems (e.g., server units). In particular, the fan assembly 270 can include one or more fans 272 (e.g., radial or axial fans) supported on a bracket support 244. A baffle 276 can be provided between the fans 272 and guide a flow of air from the corresponding fans 272. While the fans 272 are described as pushing cooled air to downstream systems, the fans 272 can be arranged to pull heated air from upstream systems and toward the heat exchanger 250. In some examples, the direction of airflow through the cooling unit 220 can be reversed by reversing the rotational direction of the fans 272, allowing the cooling unit 220 to operate in either a push or pull configuration depending on system requirements.

Further, a bracket support 244 of the casing 230 can support the fan bracket 274 at an angle relative to the cooling unit 220 (e.g., an oblique angle relative to a bottom surface of the cooling unit 220 or the bottom panel 236). In some examples, the bracket support 244 can be configured as an adjustable bracket, such that the mounting position of the bracket support 244 can be adjusted to increase or decrease the angle of the fan assembly 270. Accordingly, the fans 272 can be oriented at a tilted angle, in contrast to an upright vertical orientation in some applications. This arrangement can allow for the use of fans (e.g., radial or axial fans) to produce an air flow through a cooling unit while reducing a height required for the unit, as compared to conventional units in which fans define a rotational axis that is substantially parallel with an elongate direction of the cooling unit. Thus, the conditioned air can exit the air outlet 234 in one or more directions such as a radial direction, a lateral direction, or a generally vertical direction. For example, the fans 272 can discharge air through the air outlet 234 in a direction substantially parallel or perpendicular to the longitudinal plane 238. In some examples, the direction of airflow through the cooling unit 220 can be reversed by reversing the rotational direction of the fans 272, allowing the cooling unit 220 to operate in either a push or pull configuration depending on system requirements. In some examples, the fan assembly 270 can include axial fans that are arranged vertically relative to the bottom panel 236, and such axial fans can be 4U or less in height, to achieve similar compact arrangement within the cooling unit 220. In some examples, the bracket support 244 can guide the flow of air from the air inlet 232 away from electronic components that can be housed beneath the bracket support 244.

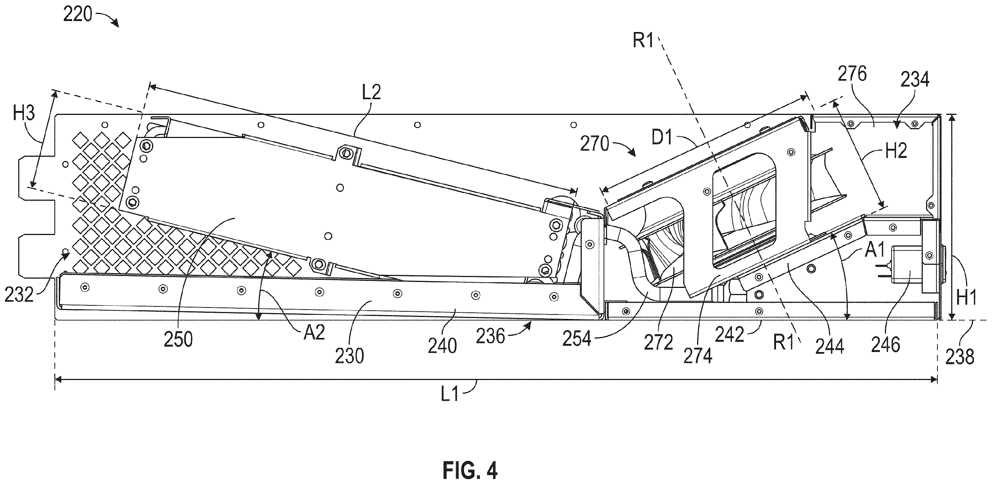

In the illustrated example, the fan assembly 270 includes two radial fans that can be configured to receive an air in a direction parallel to a rotational axis and expel the air in a direction substantially perpendicular to the rotational axis. The fans 272 are arranged side-by-side on the fan bracket 274. Each of the fans 272 of the fan assembly 270 can define a rotational axis R1 as shown in FIG. 4, and the rotational axis R1 can be oblique relative to the longitudinal plane 278 and relative to the elongate direction of the bottom panel 236. Air can exit the fan assembly 270 along an outlet axis that is perpendicular to the rotational axis R1.

In some examples, the fan assembly 270 can include a fewer number of fans (e.g., one) or a greater number of fans (e.g., three, four, five, etc.) provided on the fan bracket 274. In some examples, more than one fan assembly 270 can be provided, including two, three, four five fan assemblies and so forth. In some examples, multiple heat exchangers can be provided to achieve an improved heat transfer capacity or cooling capacity. For example, a cooling unit can include a passive air-to-liquid heat exchanger (e.g., the heat exchanger 250) and a heat transfer unit including a refrigeration cycle, and the heat transfer unit can be activated when an approach temperature between an ambient air and a liquid flowing through the heat exchanger falls below a threshold. In some examples, multiple interchangeable (e.g., via fasteners) or hot-swappable cooling units can be provided in an electronics cabinet. Accordingly, upon failure or removal of one cooling unit, then, the remaining one or more cooling units can operate to provide cooling to electrical equipment of an electronics cabinet.

With specific reference to FIGS. 4 and 5, each of the fans 272 can include a height H2 and a diameter D1. In some examples, the height H2 can be about 102 mm, and the diameter D1 can be about 200 mm, which corresponds to about 4.5U. In some examples, dimensions of the fan 272 can be determined by predetermined dimensions of an off-the-shelf fan. Thus, the diameter D1 may not be reduceable (e.g., to reduce dimensions of other components, such as the height H1 of the cooling unit 220). Although, in other configurations, a size of the fan 272 can be reduced to further reduce dimensions of other components, such as the height H1 of the cooling unit 220 (e.g., to below 4U). In the illustrated example, the fan 272, the fan bracket 274, or the fan assembly 270 can be oriented at an angle A1 relative to the longitudinal plane 278, and the angle A1 can be about 25 degrees. In some examples, the outlet axis of air can define the angle A1 relative to the longitudinal plane 278. Thus, the fan 272 can fit within the casing 230 that includes the height H1 smaller than the diameter D1 of the fan 272. Accordingly, arranging the fan assembly 270 at the angle A1 can provide a compact arrangement of the fan assembly 270 within the cooling unit 220 and help to reduce a height of the cooling unit 220.

In some examples, the height H2 can be between about 50% and about 60% of the height H1, between about 40% and about 70% of the height H1, between about 30% and about 80% of the height H1, between about 20% and about 90% of the height H1, between about 10% and about 100% of the height H1, or less than about 10% of the height H1. In some examples, the diameter D1 can be less than 100% of the height H1, greater than 100% of the height H1, greater than 110% of the height H1, greater than 120% of the height H1, greater than 130% of the height H1, greater than 140% of the height H1, or greater than 150% of the height H1. In some examples, the angle A1 can be less than about 25 degrees, less than about 20 degrees, less than about 15 degrees, less than about 10 degrees, or less than about 5 degrees relative to the bottom panel 236 of the casing 230 or the cooling unit 220. In some examples, the angle A1 can be greater than about 25 degrees, greater than about 30 degrees, greater than about 40 degrees, greater than about 50 degrees, or greater than about 60 degrees relative to the bottom panel 236 of the casing 230 or the cooling unit 220. In some examples, the angle A1 can be between about 20 degrees and about 50 degrees relative to the longitudinal plane 238.

Continuing, the heat exchanger 250 can be defined by a height H3 and a length L2. In some examples, the height H3 can be about 85 mm, and the length L2 can be about 380 mm. In some examples, the heat exchanger 250 can be angled at an angle A2 that may be about 14 degrees relative to the bottom panel 236 of the casing 230 or the cooling unit 220. In some examples, the heat exchanger 250 can be secured to the casing 230 at the angle A2 (e.g., along sides surfaces of the casing 230), and the angle A2 can be determined based on the available space within the cooling unit 220. In some examples, providing the heat exchanger 250 at the angle A2 can increase surface area for an air flow across the heat exchanger 250, and thus a cooling capacity of the heat exchanger 250. In some examples, the heat exchanger 250 can be angled toward the fan assembly 270, such that an angle between the heat exchanger 250 and the fan assembly 270 is less than about 180 degrees or less. In some examples, the fan assembly 270 and the heat exchanger 250 can be angled toward each other in a converging arrangement within the casing 230, with the fan assembly 270 facing toward the heat exchanger 250. In some examples, the rotational axis R1 can extend in a direction that is different than a longitudinal direction of the heat exchanger 250. In some examples, the fan assembly 270 and the heat exchanger 250 can be angled toward each other in a converging arrangement within the casing 230.

In some examples, the height H3 can be between about 40% and about 60% of the height H1, between about 30% and about 70% of the height H1, between about 20% and about 80% of the height H1, between about 10% and about 90% of the height H1, greater than about 90% of the height H1, or less than about 10% of the height H1. In some examples, the length L2 can be less than 200% of the height H1, greater than 200% of the height H1, greater than 210% of the height H1, greater than 220% of the height H1, greater than 230% of the height H1, greater than 240% of the height H1, or greater than 250% of the height H1. In some examples, the angle A2 can be less than about 15 degrees, less than about 10 degrees, or less than about 5 degrees relative to the bottom panel 236 of the casing 230 or the cooling unit 220. In some examples, the angle A2 can be greater than about 15 degrees, greater than about 20 degrees, greater than about 25 degrees, greater than about 30 degrees, or greater than about 35 degrees relative to the bottom panel 236 of the casing 230 or the cooling unit 220. In some examples, the angle A2 can be between about 10 degrees and about 20 degrees relative to the longitudinal plane 238.

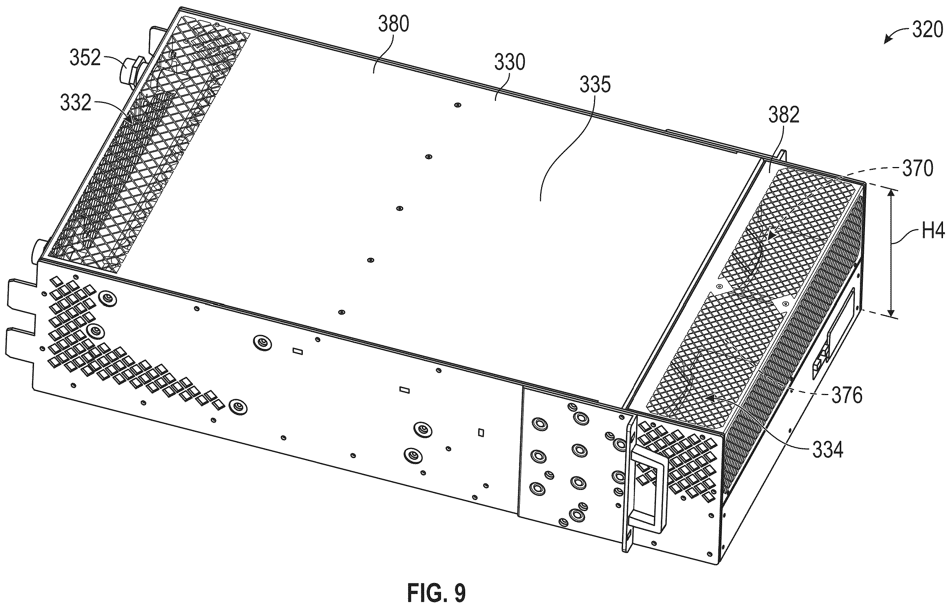

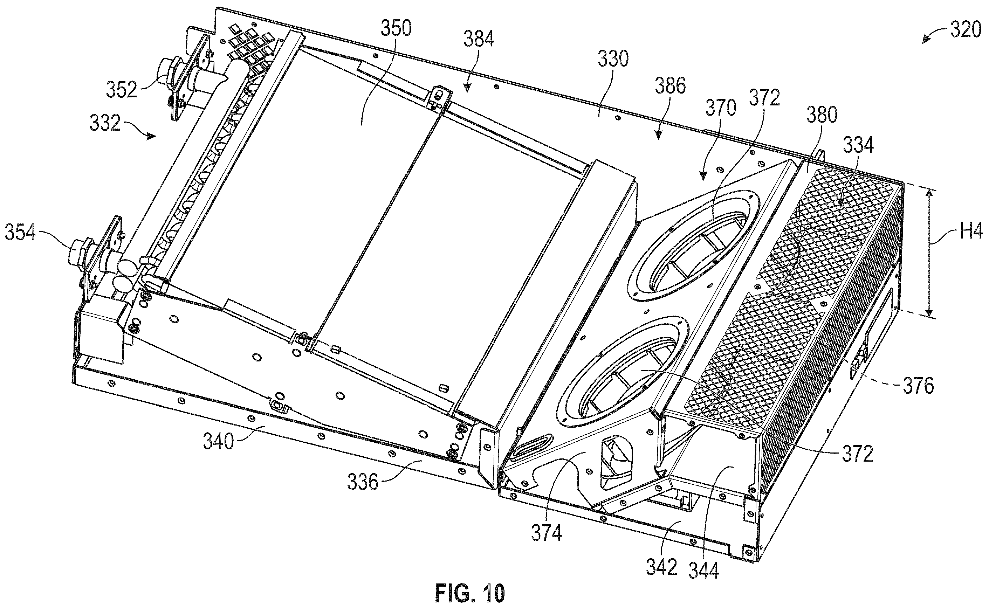

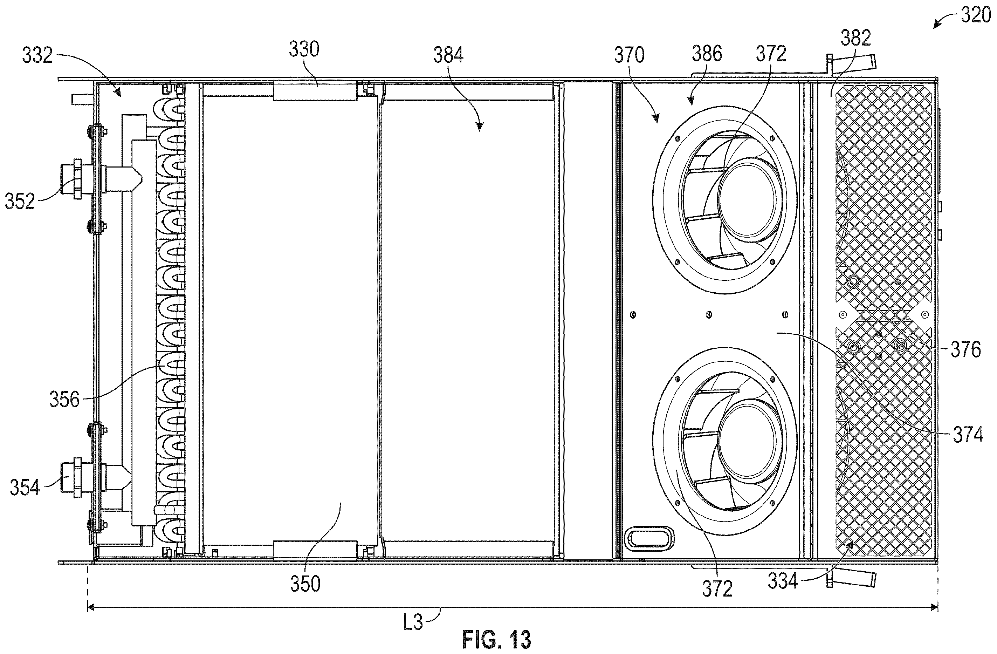

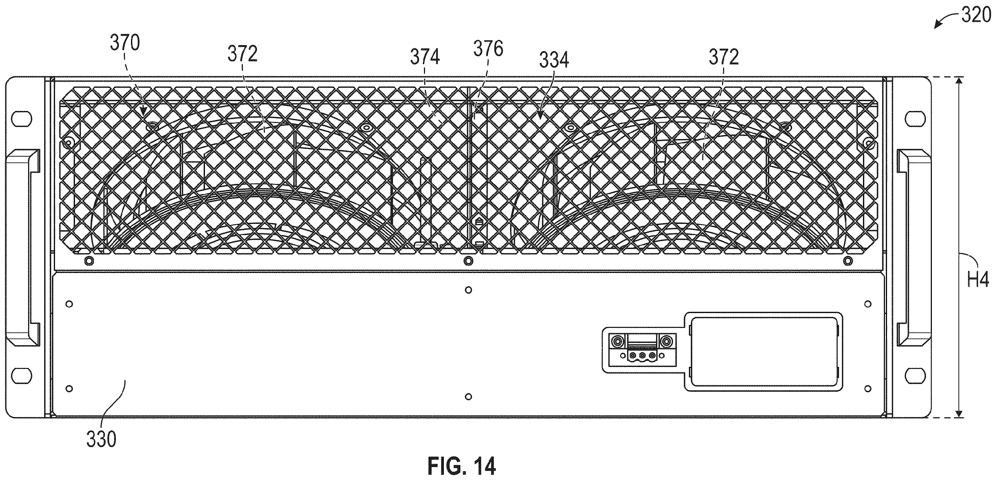

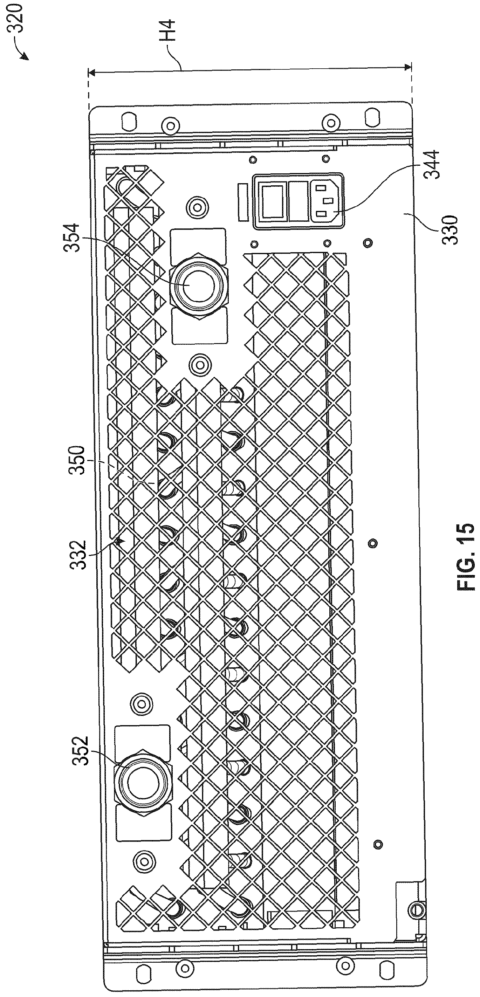

FIGS. 9-17 illustrate an example cooling unit 320, which is one particular example of the cooling unit 120 of FIG. 1 or the cooling unit 220 of FIGS. 2-8, where the examples discussed below can be advantageously employed. To that end, features of the cooling unit 320 described below include similar names and numbers that are generally similar to those used in FIGS. 2-8, and discussion of above applies to similar names and numbers unless otherwise noted or required. Further, the discussion of below can apply to similar names and numbers of the cooling unit 220 of FIGS. 2-8 above. For example, the cooling unit 320 includes a casing 330, just as the cooling unit 220 has the casing 230.

In particular, the casing 330 defines an air inlet 332 and an air outlet 334, with the casing 330 including a top panel 335 and a bottom panel 336 that defines a longitudinal plane 338. The bottom panel 336 includes a first bottom panel portion 340 and a second bottom panel portion 342. A bracket support 344 can be mounted within the casing 330 to provide structural support for internal components and guide a flow of air. A heat exchanger 350 is mounted within the casing 330 to transfer heat between air within the casing 330 and liquid coolant through coils 356 of the heat exchanger 350. The heat exchanger 350 defines a height H6 and a length L4. In the illustrated example, the heat exchanger 350 receives the coolant through a fluid inlet 352 and discharges the coolant through a fluid outlet 354. Further, a fan assembly 370 is secured within the casing 330 and is supported by the bracket support 344. The fan assembly 370 includes one or more fans 372 (e.g., radial or axial fans) that are supported by a fan bracket 374. Each of the fans 372 can define a rotational axis R2 and are configured to induce air flow through the cooling unit 320, such that air can exit air can exit the fan assembly 370 along an outlet axis that is different than (e.g., perpendicular to) the rotational axis R2. The fans 372 define a diameter D2 and a height H5. A baffle 376 can be positioned adjacent to the fans 372 and direct the air flow discharged from each of the corresponding fans 372 toward the air outlet 334. A plug 346 can extend from the casing 330 to provide electrical power and communication connections for the cooling unit 320.

In some examples, the cooling unit 320 can be configured for bidirectional airflow operation to accommodate different installation requirements and optimize cooling performance. The direction of airflow through the cooling unit 320 can be reversed by changing the rotational direction of the fans 372, allowing the cooling unit 320 to operate in either a push or pull configuration. In a forward airflow configuration, heated air can be pulled through the air inlet 332, across the heat exchanger 350 for heat transfer, then through the fan assembly 370, and out through the air outlet 334 as conditioned (cooled) air. In a reverse (e.g., backward) airflow configuration, heated air can flow through the air outlet 334, through the fan assembly 370 first, across the heat exchanger 350 for cooling, and out through the air inlet 332 as cooled air. The fan assembly 370 can face toward the heat exchanger 350 at an angle less than 180 degrees, or less than 145 degrees, creating a converging arrangement that optimizes airflow distribution within the compact casing 330.

Continuing, the cooling unit 320 configured to fit within a reduced volume of space while maintaining effective cooling performance, though it differs from the cooling unit 220 in some aspects. In the illustrated example, the casing 330 can include a smaller form factor than other casings for a cooling unit. For example, the casing 330 includes a length L3 that is reduced relative to standard cooling unit dimensions to allow the cooling unit 320 to fit within racks having smaller depths than standard rack configurations. In particular, the length L3 can be between about 600 mm and about 630 mm, as measured in a direction parallel to the longitudinal plane 338. Further, the casing 330 includes a height H4 between the top panel 335 and the bottom panel 336 and is less than 6U (about 266.4 mm) or about 4U (about 177.6 mm) as similarly discussed above relative to FIGS. 2-8.

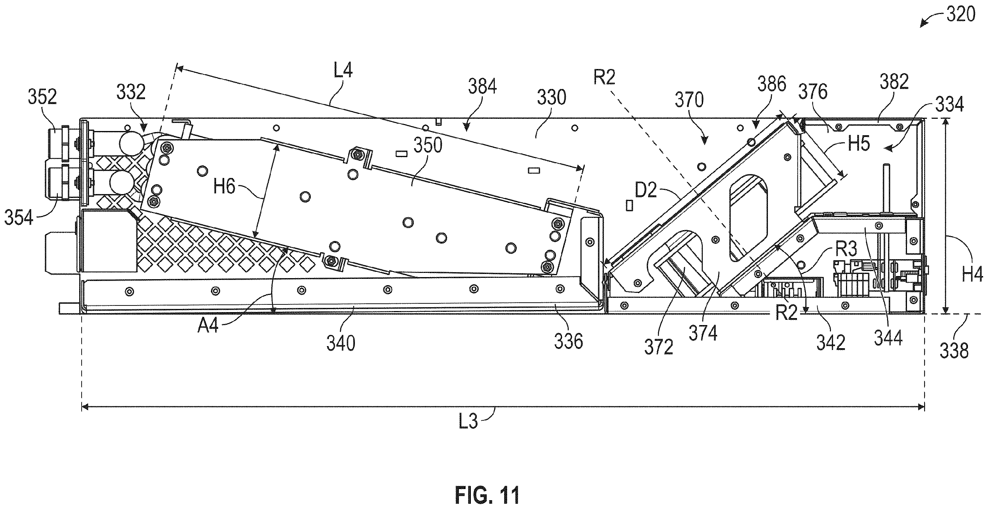

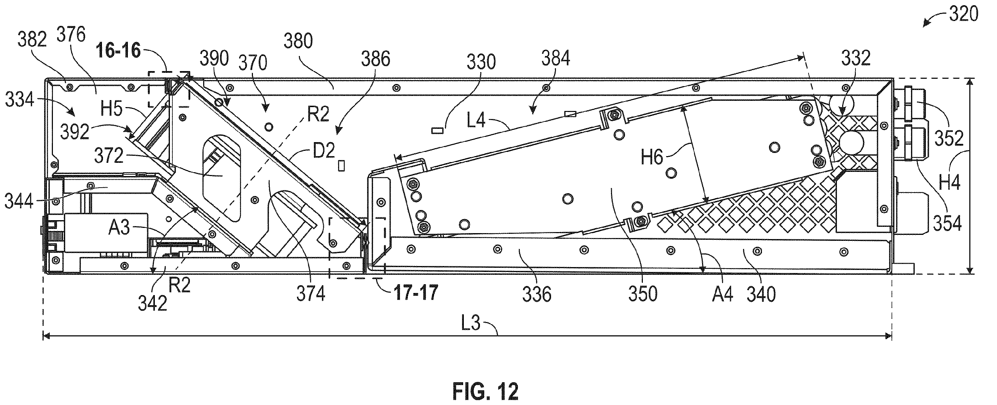

To accommodate this reduced volume within the cooling unit 320, the sub-components of the cooling unit 320 can be specifically arranged for optimal space utilization. For example, the fan assembly 370 is oriented at an angle A3 relative to the longitudinal plane 338 that is between about 40 to about 45 degrees. Similarly, the heat exchanger 350 is positioned at an angle A4 relative to the longitudinal plane 338 to maximize heat transfer surface area. In the illustrated example, the angle A4 can be about 14 degrees. In some examples, the fan assembly 370 and the heat exchanger 350 can face toward each other in a V-shaped configuration, with the angle between the fan assembly 370 and the heat exchanger 350 being less than 180 degrees. Accordingly, the fans 372 can draw air into an inlet side 390 of the fans 372 at the (oblique) angle A3 and discharge air from an outlet side 392 of the fans 372 at another oblique angle that can be 90 degrees offset from the angle A3. Further, the fan assembly 370 can pull air from the air inlet 332 across the heat exchanger 350 in a direction different than the rotational axis R2. For example, the fans 372 can pull air from the air inlet 332 across the heat exchanger 350 (e.g., from a bottom side of the heat exchanger 350 to a top side of the heat exchanger 350, as shown in FIGS. 11 and 12) at an oblique angle relative to the longitudinal plane 338 that is less than the angle A3 or the exit angle of air from the outlet side 392.

In some examples, the cooling unit 320 can provide a cooling capacity of about 7.5 kW or above while occupying a smaller overall volume relative to conventional cooling units. In some examples, the angle A3 or the angle A4 can be adjusted to provide a desired flow rate and, corresponding, a desired cooling capacity. In some examples, the bracket support 344 can be configured as an adjustable bracket, such that the mounting position of the bracket support 344 can be adjusted to increase or decrease the angle A3. In some examples, adjusting the angle A3 can help to achieve a desired level of air pressure drop across the fans 372.

The cooling unit 320 can include removable panel portions that allow the fan assembly 370 to be removed from the casing 330 independently of the heat exchanger 350, providing modularity for servicing operations. In particular, the top panel 335 includes a first top panel portion 380 and a second top panel portion 382. The heat exchanger 350 can be housed within a first compartment 384 between the first top panel portion 380 and the first bottom panel portion 340, and the fan assembly 370 can be within a second compartment 386 housed between the second top panel portion 382 and the second bottom panel portion 342. In some examples, the first top panel portion 380 can include the air inlet 332, and the second top panel portion 382 can include the air outlet 334. In some examples, the first top panel portion 380 and the second top panel portion 382 can form a top side and lateral sides of the casing 330, such that air can be drawn into the internal space of the casing 330 through the top side and a lateral side (e.g., left side as shown in FIG. 9) of the casing 330, and air can be discharged from the internal space of the casing 330 through the top side and a lateral side (e.g., right side as shown in FIG. 9) of the casing 330. In some examples, the fans 372 may be interchangeable and can be secured with fasteners (e.g., screws) to allow for easy removal and installation during servicing or replacement operations.

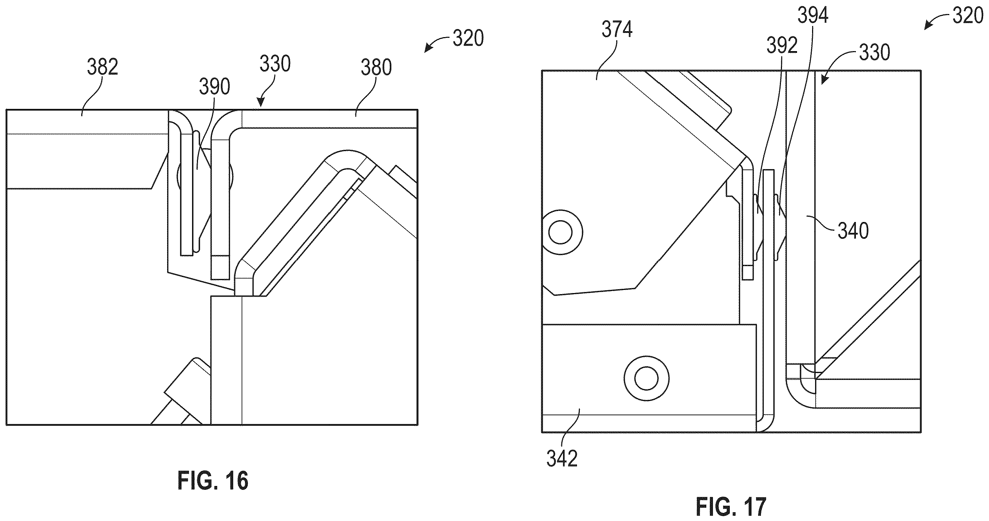

With specific reference to FIGS. 16 and 17, various sealing elements (e.g., gaskets) can be provided between portions of the casing 330. For example, a seal 390 is provided between the first top panel portion 380 and the second top panel portion 382 as shown in FIG. 16. A seal 392 is provided between the fan bracket 374 and the second bottom panel portion 342, and a seal 394 is provided between the first bottom panel portion 340 and the second bottom panel portion 342. In some examples, the seals 390, 392, 394 can provide sealing between portions of the casing 330 and prevent fluid leakage from the cooling unit 320 or prevent debris from entering the inner volume of the casing 330.

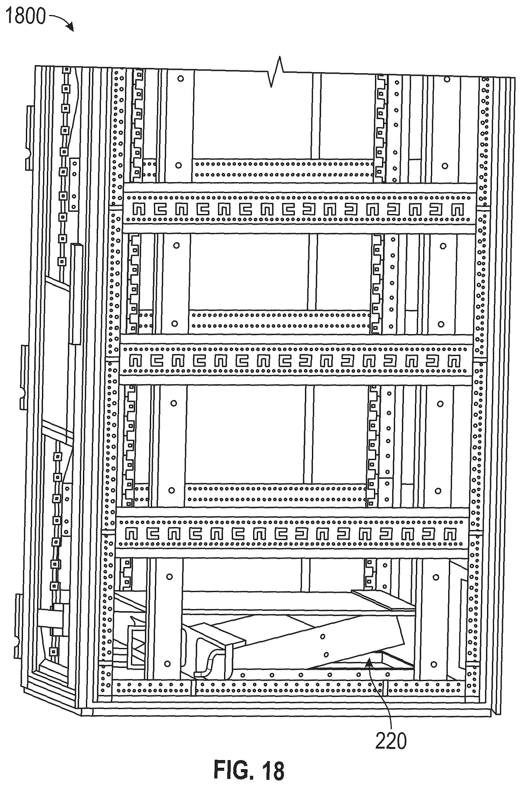

FIG. 18 illustrates an in-rack cooling unit installed within a rack 1800 of electrical equipment, similar or identical to the in-rack cooling unit 120 installed within the cabinet 100 shown in FIG. 1. While the cooling unit 220 is shown installed in the rack 1800, various examples of cooling units including the cooling unit 320 or other types of similar cooling units can be readily installed depending on specific application requirements. For example, a cooling unit with reduced depth dimensions (e.g., the cooling unit 320 with approximately 600 mm depth) can be advantageously installed in space-constrained environments or racks with smaller footprints. As discussed above, these in-rack cooling units can be particularly well-suited for deployment in edge data centers, remote research facilities, nautical vessels, aircraft, field hospitals, and other environments where space optimization and weight reduction are critical considerations. In comprehensive testing, an in-rack cooling unit substantially identical to the cooling unit 220, with a compact height of 4U (as defined by the distance between the top panel and bottom panel), successfully achieved a cooling capacity of up to 8 kW. Further, the total weight of the in-rack cooling unit when constructed with a steel casing was less than 23 kg, and the total weight of the in-rack cooling unit when constructed with an aluminum casing was less than 15 kg.

The previous description of the disclosed examples is provided to enable any person skilled in the art to make or use the disclosed technology. Various modifications to these examples will be readily apparent to those skilled in the art, and the generic principles defined herein may be applied to other examples without departing from the spirit or scope of the disclosed technology. Thus, the disclosed technology is not intended to be limited to the examples shown herein but is to be accorded the widest scope consistent with the principles and novel features disclosed herein.

Also as used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either," "one of," "only one of," or "exactly one of." For example, a list of "one of A, B, or C" indicates options of: A, but not B and C; B, but not A and C; and C, but not A and B. A list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more of A, one or more of B, and one or more of C. Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

Also as used herein, unless otherwise specified or limited, "configured to" indicates that a component, system, or module is particularly adapted for the associated functionality. Thus, for example, an XX configured to YY is specifically adapted to YY, as opposed to merely being generally capable of doing so.

In some implementations, devices or systems disclosed herein can be utilized, manufactured, installed, etc. using methods embodying aspects of the disclosed technology. Correspondingly, any description herein of particular features, capabilities, or intended purposes of a device or system is generally intended to include disclosure of a method of using such devices for the intended purposes, of a method of otherwise implementing such capabilities, of a method of manufacturing relevant components of such a device or system (or the device or system as a whole), and of a method of installing disclosed (or otherwise known) components to support such purposes or capabilities. Similarly, unless otherwise indicated or limited, discussion herein of any method of manufacturing or using for a particular device or system, including installing the device or system, is intended to inherently include disclosure, as examples of the disclosed technology, of the utilized features and implemented capabilities of such device or system.

Features which are described in the context of separate embodiments may also be provided in combination in a single embodiment. Features which are, for brevity, described in the context of a single embodiment, may also be provided separately or in any suitable sub-combination, or combined as new embodiments. The applicant hereby gives notice that new claims may be formulated to one or more features and/or combinations of such features during the prosecution of the present application or of any further application derived therefrom. Feature(s) of or related to the in-rack cooling unit or other devices or components described may be incorporated into/used in corresponding methods and vice versa.

Also as used herein, unless otherwise limited or defined, the terms "about," "substantially," and "approximately" refer to a range of values ± 5% of the numeric value that the term precedes. As a default the terms "about" and "approximately" are inclusive to the endpoints of the relevant range, but disclosure of ranges exclusive to the endpoints is also intended.

Also as used herein, unless otherwise defined or limited, the term "lateral" refers to a direction that does not extend in parallel with a reference direction. A feature that extends in a lateral direction relative to a reference direction thus extends in a direction, at least a component of which is not parallel to the reference direction. In some examples, a lateral direction can be a radial or other perpendicular direction relative to a reference direction.

Unless otherwise specifically indicated, ordinal numbers are used herein for convenience of reference, based generally on the order in which particular components are presented in the relevant part of the disclosure. In this regard, for example, designations such as "first," "second," etc., generally indicate only the order in which a thus-labeled component is introduced for discussion and generally do not indicate or require a particular spatial, functional, temporal, or structural primacy or order. Relatedly, similar or identical components may be referred to with different ordinal numbers in different contexts.

Also as used herein, unless otherwise defined or limited, directional terms are used for convenience of reference for discussion of particular figures or examples or to indicate spatial relationships relative to particular other components or context, but are not intended to indicate absolute orientation. For example, references to downward, forward, or other directions, or to top, rear, or other positions (or features) may be used to discuss aspects of a particular example or figure, but do not necessarily require similar orientation or geometry in all installations or configurations.

## Claims

1. An in-rack cooling unit for cooling electrical equipment within a rack, comprising:
a casing, including;
an air inlet;
an air outlet;
a top panel;
a bottom panel defining a longitudinal plane, a distance between the top panel and the bottom panel defining a height of the casing that is less than 6 rack units;
a fluid inlet;
a fluid outlet;
a heat exchanger fluidly connected between the fluid inlet and the fluid outlet; and
a fan defining a rotational axis that extends at a first oblique angle relative to the longitudinal plane, the fan pulling air from the air inlet across the heat exchanger and discharging conditioned air through the air outlet in a direction different than the rotational axis.

2. The in-rack cooling unit of claim 1, wherein the heat exchanger is an air-to-liquid heat exchanger or a liquid-to-air heat exchanger.

3. The in-rack cooling unit of claim 1 or claim 2, wherein the height of the casing is less than 4 rack units.

4. The in-rack cooling unit of claim 1, claim 2 or claim 3, wherein the fan draws air into an inlet side of the fan at the first oblique angle and discharges air from an outlet side of the fan at a second oblique angle that is 90 degrees offset from the first oblique angle.

5. The in-rack cooling unit of claim 1 or of any of claims 2 to 4, wherein the fan is oriented at the first oblique angle of between about 20 degrees and about 50 degrees relative to the longitudinal plane.

6. The in-rack cooling unit of claim 1 or of any of claims 2 to 5, wherein the heat exchanger is oriented at a third oblique angle of between about 10 degrees and about 20 degrees relative to the longitudinal plane.

7. The in-rack cooling unit of claim 1 or of any of claims 2 to 6, wherein the fan is angled toward the heat exchanger.

8. The in-rack cooling unit of claim 1 or of any of claims 2 to 7, wherein the in-rack cooling unit provides a cooling capacity of between about 7 kW and about 8 kW.

9. The in-rack cooling unit of claim 1 or of any of claims 2 to 8, wherein the fan pulls air from the air inlet across the heat exchanger in a direction different than the rotational axis.

10. The in-rack cooling unit of claim 1 or of any of claims 2 to 9, wherein the bottom panel includes a first bottom panel portion supporting the heat exchanger and a second bottom panel portion supporting the fan, and
wherein a first seal is arranged between the first bottom panel portion and the second bottom panel portion.

11. The in-rack cooling unit of claim 10, wherein the top panel includes a first top panel portion and a second top panel portion that includes the air inlet or the air outlet, and
wherein a second seal is arranged between the first top panel portion and the second top panel portion.

12. A method of cooling electrical equipment within a rack, the method comprising:
providing an in-rack cooling unit having a casing that includes an air inlet and an air outlet, the casing having a height of less than 6 rack units;
providing a heat exchanger that includes a liquid inlet and a liquid outlet within the casing;
orienting a plurality of fans within the casing at a first oblique angle relative to a longitudinal plane that extends between the air inlet and the air outlet of the casing;
inducing a flow of air from the air inlet across the heat exchanger using the plurality of fans; and
discharging conditioned air through the air outlet in a direction different than the first oblique angle.

13. The method of claim 12, further comprising:
positioning the heat exchanger at a second oblique angle relative to the longitudinal plane such that the plurality of fans and the heat exchanger converge toward each other.

14. The method of claim 12 or claim 13, wherein the first oblique angle is between about 20 degrees and about 50 degrees relative to the longitudinal plane.

15. The method of claim 13, claim 14 or claim 15, wherein the second oblique angle is between about 10 degrees and about 20 degrees relative to the longitudinal plane.
